# NEW EUROPEAN PATENT SPECIFICATION

(11) **EP 0 227 411 B2**
(45) Date of publication and mention of the opposition decision: **03.08.1994**
(45) Mention of the grant of the patent: 17.04.1991
(21) Application number: 86309801.8
(22) Date of filing: 16.12.1986
(51) Int. Cl.: H03K 17/66

(54) **Inductive circuit arrangements**
Induktive Schaltungsanordnungen
Circuits inductifs

(30) Priority: 16.12.1985 GB 8530930
(43) Date of publication of application: 01.07.1987
(73) Proprietor: NATIONAL RESEARCH DEVELOPMENT CORPORATION, London SE1 6BU (GB)
(72) Inventor: Mansfield, Peter, Beeston Nottingham NG9 1BS (GB); Coxon, Ronald John, Wollaton Nottingham NG8 2AB (GB)
(74) Representative: Davis, Norman Norbridge

(56) References cited:
- WO-A-85/04258
- GB-A- 1 597 258
- GB-A- 2 084 827
- GB-A- 2 159 672
- US-A- 4 251 742
- US-A- 4 490 655
- J. Markus, "Sourcebook of Electronic Circuits", McGraw-Hill Book Company, 1968, page 225, "Photoflash Supply" and "Low-Cost Strobe".
- J. Markus, "Modern Electronic Circuits Reference Manual", McGraw-Hill Book Company, 1980, page 876, "RLC Bridge".

## Description

This invention relates to inductive circuit arrangements and is concerned with arrangements which enable the current flow through an inductive coil to be rapidly switched on and off or reversed. The invention has particular application in nuclear magnetic reso- nace (NMR) imaging machines.

In many applications of nuclear magnetic resonance (NMR) it is often required to switch on or off or to reverse magnetic fields and especially magnetic gradient fields and to effect such switching or reversal as rapidly as possible. Switching of magnetic gradient fields is important in NMR imaging applications especially where high speed is required. An example of such an application is in the echo planar imaging (EPI) technique as described in British Patent No. 1,596,160. In EPI there is a requirement to switch trapezoidal gradient fields with a switching time of around 25 f..ls for best effect. These gradient fields are created by passing electrical currents through inductive coil arrangements which may have non-zero resistance. For low resolution imaging low currents and small coil assemblies can be utilised and it is possible to use linear amplifiers to achieve the required switching rates and gradient amplitudes. However if high resolution is required larger gradient fields must be employed and to achieve the required high switching rates extremely high power amplifiers are necessary. It is believed that this is one of the major obstacles to the commercial development of ultra highspeed NMR imaging techniques like EPI.

The power requirements for the rapid switching of current through an inductance will be appreciated from a consideration of the theoretical background. Let a step voltage V be applied to an inductance L through a resistor r then the size of current i is given by the well known expression 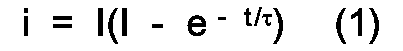 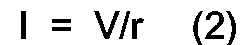 and the time constant τ is given by

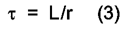

The magnetic energy E contained in the coil at any time t is given by

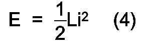

The peak power P_{L} required to establish this energy in the coil is

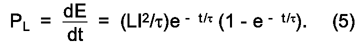

The steady-state power dissipation Pᵣ in the coil is simply

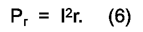

For very low winding resistance, this power can be made arbitrarily low. However, for given value of inductance Land rise time, equation (5) determines the peak power requirements of the driver amplifier. For linear amplifiers this situation presents something of a dilemma. Peak powers and voltages exceeding the capability of the amplifier may be required for short durations only, in order to establish the steady state current I. Then according to equation (6), the power requirement may drop to an arbitrarily low figure, though I may be high.

Linear amplifiers with both high voltage and high current capability are not readily available but in any event are an inefficient and uneconomic approach for gradient switching.

For superconductive coils, r = 0 so that τ → ₀₀, equation (3). In this case, it would take an infinite time (in practice a long time) to establish any current through L. But having established a current, no power would be required to maintain it.

It is known from British Patent Publication No. 2084827Ato provide an inductive circuit arrangement comprising four switches connected in a bridge configuration, current supply terminals from an electrical power supply connected to opposite ends of the bridge, an inductive coil connected across the bridge, and means for operating the switches so that current can flow in either direction through the coil depending on the setting of the switches, and a capacitor connected across the bridge. However, successive switch reversals of current through the coi I do not establish the original magnitude of the previous current in the reverse direction immediately after reversal of the magnetic field. This is due to ohmic losses in the circuit. In order to speed up the rise in current to the required value, the solution proposed is to temporarily increase the magnitude of the voltage supply immediately after switching. This arrangement therefore requires a power supply which can be intermittently changed in magnitude.

It is an object of the invention to provide an inductive circuit arrangement in which the current through the coi I can be fully reversed without the need to modify the power supply to the bridge.

Accordingly the invention is characterised in that a switch is connected in series with the capacitor and means are provided for operating the series switch so as to connect the capacitor across the coi I at least for a sufficient period of time until the voltage across the capacitor reduces to zero and then isolate the capacitor from the bridge configuration. Also means are provided for replenishing ohmic losses in the circuit from an external source when the series switch is open.

Preferably the means for replenishing ohmic losses comprises trickle charge means connected to the capacitor to enable the capacitor to be charged to a predetermined voltage after discharge It is desirable to ensure that the said predetermined voltage is greater than the voltage across the supply terminals.

Preferably a unidirectional current flow device is connected in series with the current supply terminals to prevent flow of current through the current supply terminals in the reverse direction. Also the various switches may be shunted by unidirectional current flow devices.

The invention is applicable both to circuit arrangements incorporating coils having finite resistance and to circuit arrangements incorporating superconductive coils, in which case it may not be necessary to provide a potential difference across the supply terminals.

To provide start-up energy forthe circuit initiating charge means comprising an additional power supply can be connected through a switch to initially charge the capacitor means to a peak voltage to provide the requisite electrical energy to establish the required current flow in the said coil means.

It may also be desirable to provide a switched parallel path across the bridge to maintain a substantially constant value of current through the current supply terminals irrespective of the settings of the switches in the bridge configuration.

In a modification of the invention the two arms of the bridge are connected to different current supply terminals each connected to respective electrical power supplies at different voltage levels to enable different values of current flow to be established through the coil in respective opposite directions. Switches each connected in series with a respective capacitor are connected across each arm respectively and means are provided for operating the series switches so as to connect each respective capacitor across the coil at least for a sufficient period of time unti I the voltage across that capacitor reduces to zero and then isolate that capacitor from the arms.

In certain embodiments of the invention the capacitor means is used as a temporary energy store only and a second inductive coil means is provided as a more long-term store. Such an arrangement is useful where immediate current reversal in an operating coil is not required. In one such embodiment a further bridge configuration with associated further current supply terminals is provided with a further inductive coil means connected across the said further bridge configuration and the capacitor means is also connected in series with a further switch across the further current supply terminals. With such an arrangement the energy in the operating coil is first transferred to the capacitor means in the manner described above and is then transferred to the further inductive coil means where it can be stored indefinitely, with any losses if need be being made up from the voltage source connected across the further current supply terminals.

In order that the invention may be more fully understood reference will now be made to the accompanying drawings in which :
Figure 1 is a circuit arrangement embodying the invention,
Figure 2 shows waveforms explanatory of Figure 1,
Figure 3 illustrates a modification for Figure 1,
Figure 4 is a circuit embodying the invention for enabling opposite current flows in a coil to have different amplitudes,
Figure 5 illustrates various current waveforms possible by using the invention,
Figure 6 illustrates an embodiment of the invention in which two inductive coils are used,
Figure 7 illustrates another embodiment of the invention in which a second coil is used for energy storage, and
Figure 8 is an emnodiment of the Invention utiils- ing solid state switches.

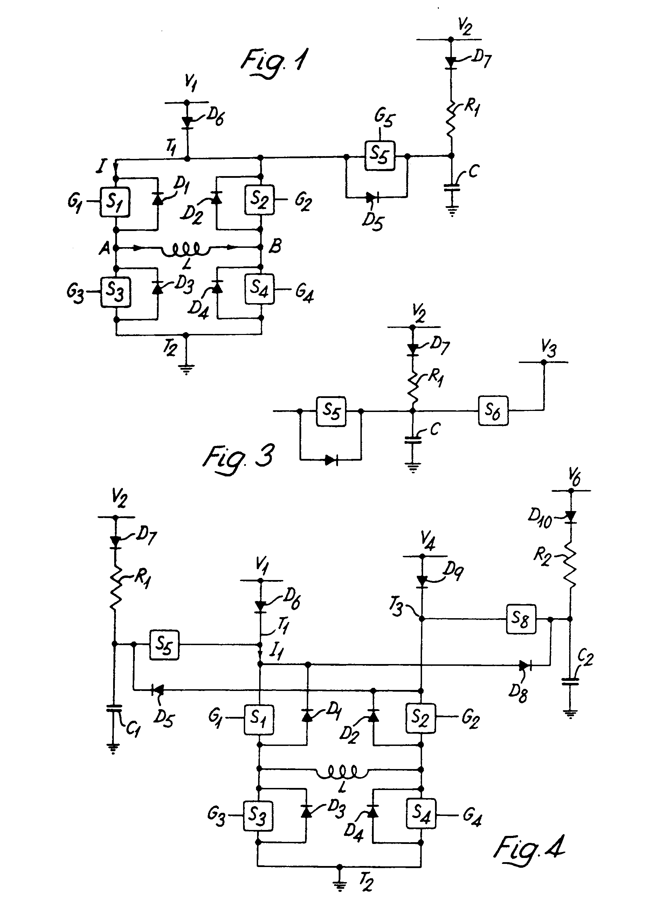

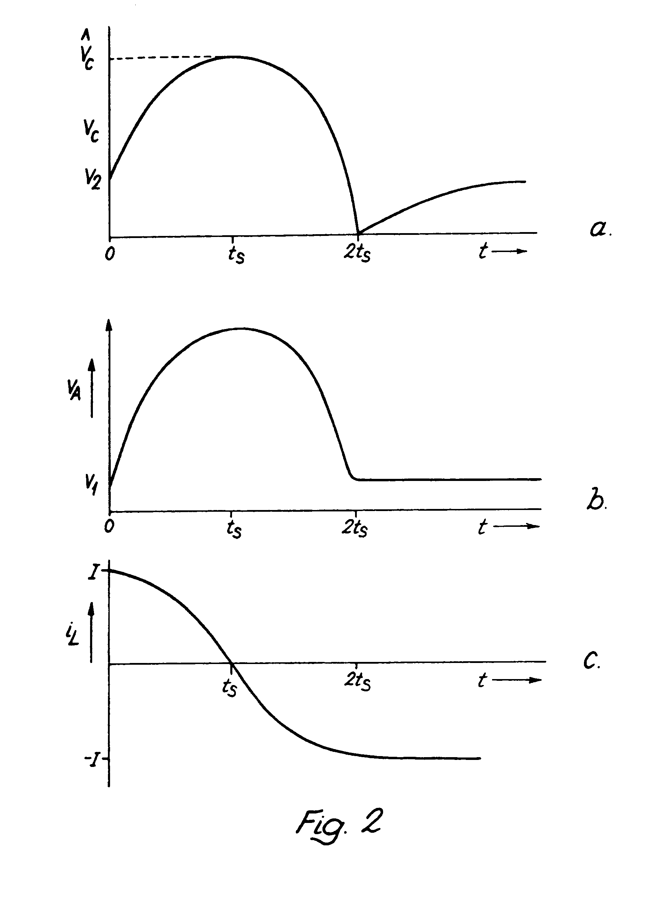

Referring now to Figure 1 there is illustrated therein a bridge configuration of four switches S₁, S₂, S₃ and S₄. Each switch is shunted by a respective diode D₁, D₂, D₃ or D₄. All the diodes are conductive in the same direction. An inductive coil L is connected across the bridge between points A and B. The bridge has current supply terminals T₁ and T₂, terminal T₂ being earthed and terminal T₁ being supplied from a voltage or current supply V₁ through a diode D₆. Aser- ies connection of a capacitor C and switch S₅ is connected across the bridge between terminals T₁ and T₂ and switch S₅ is shunted by a diode D₅. Capacitor C can be charged from a voltage supply V₂ through a diode D₇ and resistor R₁. The various switches S₁ to S₅ are controlled by signals applied along lines G₁ to G₅ respectively.

To understand the operation of the circuit shown in Figure 1 let it be assumed initially that switches S₁ and S₄ are closed and that switches S₂ and S₃ are open. With this arrangement of the switches current will flow through coil Lfrom terminal A to terminal B. If now at a time t = 0 switches S₁ and S₄ are switched off simultaneously the magnetic field in coil L will collapse and will generate an emf across the coil and by Lenz's law point A will be negative with respect to point B. Point A is clamped to earth terminal T₂ through diode D₃ and since point B is therefore positive there will be a continuous path for the current flowing in coil L through diodes D₂ and D₃, diode D₅ and capacitor C. The energy in coil Lwill therefore be dumped into capacitor C where it will be stored as electrostatic energy. While this charging of capacitor C takes place switches S₂ and S₃ can be closed but the timing of their closure is not critical since current is flowing during this time through diodes D₂ and D₃. Switch S₅ is also closed during this time without affecting the operation of the circuit. The current through coil L reaches zero at a time t = tₛ at which instant capacitor C becomes fully charged to a peak value of voltage V_{c}. This time tₛ is defined by

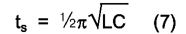

The current flow will reverse through the now closed switches S₂, S₃ and S₅ and capacitor C will entirely discharge to generate a current flow of magnitude-I from B to A in the reverse direction through coil L after a time 2tₛ.

Neglecting the forward diode resistance, the total energy initially in the inductor at time t = 0 is transferred to the capacitor. i.e. 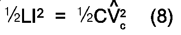 where _{c} is the peak voltage appearing on C. Since L and C form a tuned circuit with frequency f is given by 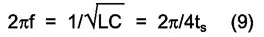 the energy transfer time or switching time, tₛ, can be chosen by an appropriate value of C. The capacitor voltage V_{c} during a switch, is shown in Figure 2(a). At t = 0, V_{c} = V₂. After energy transfer at T = tₛ, V_{c} = V_{c.} Capacitor C discharges in the next 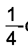 cycle through closed switch S₅. The discharge path is through switches S₂ and S₃ thereby establishing a reversed current, -I, through coil L. At the end of the discharge period, when t = 2tₛ, V_{c} ≃ 0 and at this point in time switch S₅ is opened isolating C from the circuit. Thereafter the capacitor is trickle charged through resistor R₁ until V_{c =} V₂.

The voltage V_{A} across the terminals T₁ and T₂ and the current i_{L} through coil L are shown in Figure 2(b) and Figure 2(c) respectively. Prior to reversal, V_{A} ≃ V₁ and i_{L} = I. At time t = tₛ, i_{L} = 0 and V_{A} = V̂_{c}. The diode D₆ protects the low voltage power supply during the switching operation and allows a smooth transition back to V₁ following current reversal. Since D₁ conducts when S₁ is switched off, a smooth transition from I to -I obtains, with no discontinuous glitches at the zero-crossing.

The voltage V₂ is variable and serves to make good energy losses in the system due to finite diode and switch resistances.

As described the switch works with superconductive coils.

The operation of the circuit of Figure 1 assumed an initial steady state current flowing in the coil. However, from Figure 2 it can be seen that at time t = t, i_{L} = 0. That is to say, the circuit is switched off. The conditions to switch on from i_{L} = 0 are therefore those indicated, namely V_{c} = V_{c}. In order to achieve this, the circuit as it stands must be cycled prior to actual operation to establish the correct working voltages. However, capacitor C will not hold its charge indefinitely and V_{c} will slowly decay from V_{c} to V₁ due to leakage resistance. Typical leakages allow V_{c} to be held for up to 100 ms without problem.

To avoid droop, the circuit of Figure 1 must be modified to take an additionnal power supply which acts as an initiating charge means and is capable of supplying the full peak voltage V_{c} to capacitor C. This modification is sketched in Figure 3, in which a supply A voltage V₃ equal in magnitude to peak voltage V_{c} is connected to capacitor C via a switch S₆. Switch S₆ is kept on when all other switches are off, that is, between pulse sequences and ensures that the requisite electrical energy is stored in capacitor C to establish the required current flow in coil L when desired. As soon as current is required through coil L, S₆ is switched off, S₅ is switched on and the bridge is activated. Discharge of capacitor C through the bridge immediately establishes the required magnitude of current flow in coil L. Once current is established, the operations continue as previously described. On final switch off, V₃ is again coupled to capacitor C via switch S₆.

The fact that S₁ to S₄ are initially all off means that the load on supply V₁ changes and voltage V_{A} varies. This may be obviated by adding a third arm to the bridge of Figure 1. This comprises a switched load connected between terminal T₁ and earth which is normally off. However, when no current through coil L is required, the third arm shunts current through diode D₆ to earth thereby holding V_{A} constant.

In the Figure 1 circuit the bridge configuration is shown as comprising four switches. Two of these switches, for example switches S₂ and S₄, may be replaced by pairs of terminals for connection to individual current supply sources which replace source V₁. A duplicate of capacitor C and its associated switch S₅ and bypass diode D₅ is connected to the opposite end of the bridge to switch S₅ and point A or B is earthed instead of terminal T₂. Diodes are also included at each end of the bridge.

In the circuit described in Figure 1 the magnitude of the forward and reverse currents are equal. However, in some NMRapplications, unequal magnitudes of current are required. The basic principles of switching described above can be adapted to this situation as indicated in Figure 4.

In the circuit shown in Figure 4 like parts have like references to Figure 1 but in Figure 4 the two arms of the bridge comprising the switches S₁ and S₂ are taken to two different current supply terminals T₁ and T₃ supplied from voltage sources V₁ and V₄ of different magnitudes. Separate capacitors C₁ and C₂ are connected to terminals T₁ and T₃ through switches S₅ and S₈ respectively. Terminal T₁ is connected to capacitor C₂ through a diode D₈ and terminal T₃ is connected to capacitor C₁ through a diode D₅ shunted by diodes D₅ and D₈. Capacitor C₁ is trickle charged from a voltage source V₂ through a protective diode D₇ and resistor R₁. Capacitor C₂ is tricle charged from a voltage source V₆ through a protective diode D₁₀ and resistor R₂.

Let an initial current I₁ flow through switch S₁, coil L and switch S₄. On turn-off of switches S₁ and S₄ capacitor C₁ charges, storing the initial energy ½ LI₁2.

The reverse current I_{2≠l1} then flows through switch S₂, L and switch S₃ with appropriate gating, provided that the energy equivalent of ½LI₂² was previously stored on the capacitor C₂.

If the switching process is only seldomly repeated, the necessary peak voltages on C₁ and C₂ may be ensured by adding two circuit arrangements as described in Figure 3.

In order to present roughly constant loads to the two power supplies, V₁ and V₂, each half of the bridge, i.e. S₁, Sₐ and S₂, S₄ can be shunted by additional current switches from both D₆ and D₉ to earth.

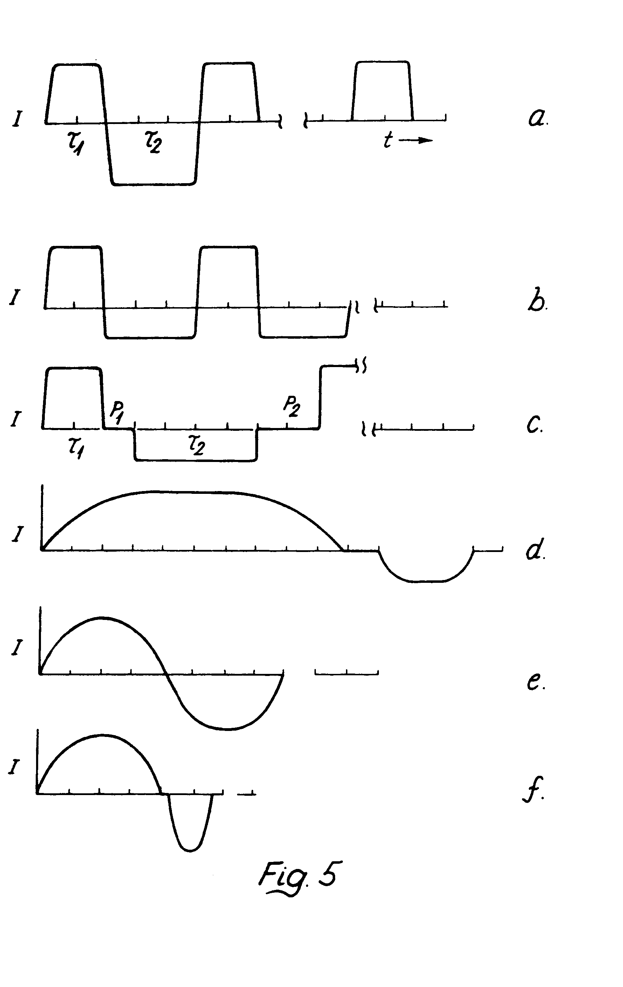

The circuits described are capable of producing a variety of useful current waveforms. One example is a trapezoidal like burst of equal amplitude positive and negative currents with periods τ₁ and τ₂, see Figure 5(a). A similar current waveform with unequal positive and negative currents is shown in Figure 5(b). Since the circuits actually switch off at a zero-crossing, time delays P₁ and P₂ may be interposed as indicated in Figure 5(c).

The trapezoidal edges in all cases are cosinusoi- dal with a rise or fall time of tₛ, which is experimentally accessible. For rapid switching tₛ is short, but this may be lengthened as in Figure 5(d). The circuit can also be used to generate true sinusoidal waveforms, Figure 5(e) or mixed sinusoids, Figure 5(f).

Arrangements for energy storage using capacitors have been described above. This is convenient since tuned circuits naturally interconvert between magnetic and electrostatic energy. In practice equations (8) arid (9) dictate the storage capacitance and the peak voltage. Assuming the components can withstand this voltage, there is still the problem oftop- up provided by the supply V₂ in Figure 1, and the initiating charge provided by V₃ in Figure 3. Both arrangements require relatively high voltage power supplies and in the case ofV2, the current drains can be significant. For one shot waveforms there is no problem. But with repeating waveforms, as used in EPI, HT or even EHT power supplies by be required.

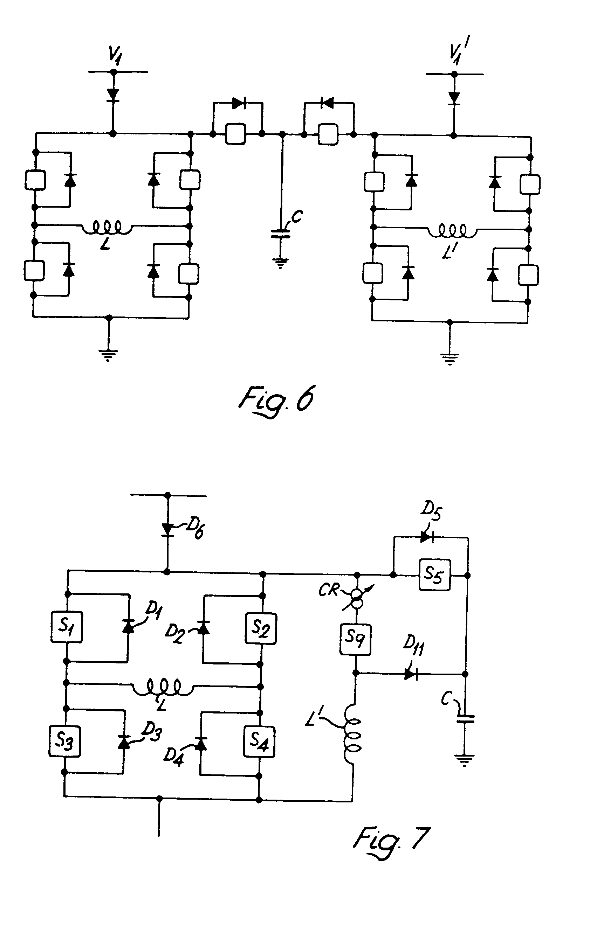

An attractive and alternative approach is to use the capacitor C as a short term energy store, transferring the energy to another storage inductance, L', placed well away from the primary coil L. Acircuit arrangement is shown in Figure 6 using two bridges and two low voltage power supplies V₁ and V'₁. If L = L' then V₁ ≃V'₁. Losses in the system are made up by passing extra current through L'. The losses referred to arise from power dissipation in the diodes and switches. Long term losses in the inductance (I²r) are made up from the power supply. In a superconductive coil, these are zero. Thus once the current I is achieved in L or L' the current would be maintained with no power consumption. Note that in this arrangement, capacitor C can be small. The rise time would be limited purely by the voltage capabilities of the switches and diodes. The storage capacitor is required to hold charge for only a short time and no top-up voltage source or high voltage start-up supply is required.

Although a four element bridge for storage coi I L' strictly speaking, is not required, the arrangement of Figure 6 provides a more or less constant lead for supply V'₁. As in the previous circuits, the bridge for coi I L should be shunted with a third arm to provide a current drain on V₁ when all four switch elements of that bridge are off.

An alternative circuit is shown in Figure 7. In this arrangement as in Figure 1 energy is momentarily stored in capacitor C when reversing the current direction through L. However, when it is desired to switch off all four switches S₁ to S₄, the magnetic energy ½LI² in coil L is first transferred to coil L' via switch Sg. Current through Sg is controlled by a current regulator CR. The current flow through coil L'and its energy 2L'I'² in coil L' is then maintained from the same supply V. Ashorttime before current flow in coil L is required switch Sg is opened and the energy in coil L' is dumped into capacitor C thus providing the necessary initial condition for start-up. This means that the current drain is fairly constant thus avoiding transient problems in the low voltage power supply. No HT or EHT top-up supplies are needed in this arrangement.

The various switches referred to can be bidirectional mechanical devices, bidirectional solid-state devices, e.g. FET's, standard high power transistors, ScR's, unidirectional vacuum tubes or gas filled thyr- atrons. All can be made to function with appropriate driving circuitry. Naturally for high speed operation, mechanical switches are not as useful.

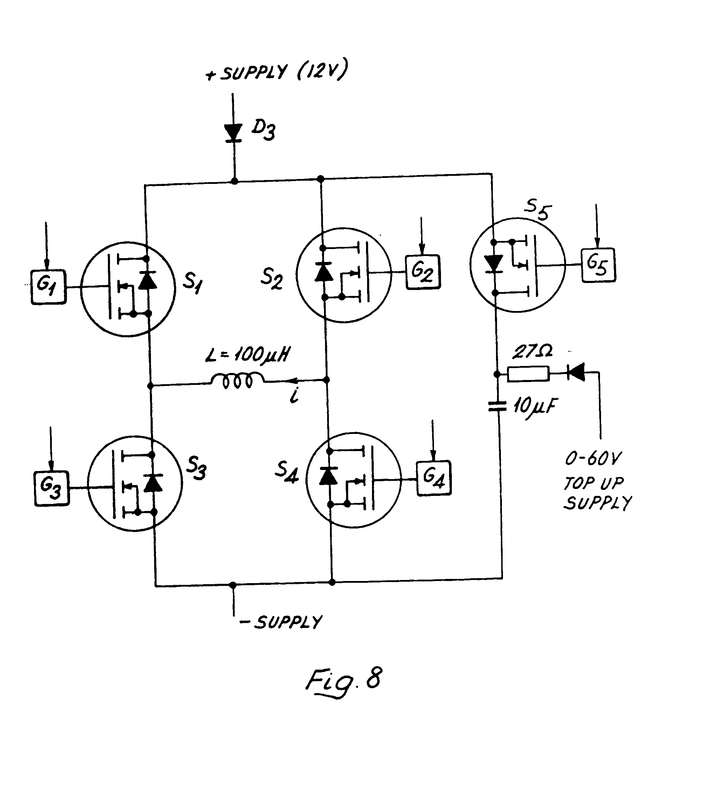

A practical circuit based on Figure 1 is shown in Figure 8. Power FET's (HEXFETS IRF130) are used as the switches S to S₅, the integral body diode of these devices being employed for the return current paths.

A switching time tₛ of 50 µs was chosen in order to keep the peak capacitor voltage below the device limit of 100V using equations (8) and (9). A capacitor of 10 µF satisfies the requirements.

Switch S₅ is arranged to open between transitions after the current has settled (i.e. 2tₛ after the last transition) to enable the capacitor voltage to be topped up to V₂ as described earlier and shown in Figure 2(a). This switch doses during a transition, when energy is being transferred into C via S₅'s body diode or via S₅ itself when it has closed, and S₅ remains closed until the stored energy in C has been returned to the coil at time t = 2tₛ.

Each HEXFET has its own high speed opto- isolated gate drive circuit, the gate signals G₁ to G₅ are derived from TTL logic designed to supply the appropriate timings to the five gates.

In this arrangement there is no requirement for instantaneous switching or simultaneous switching of any of the devices. Also, there is always a current path in circuit with coi L, either via the devices or the diodes during transitions thus minimising the possibility of'glitches'.

Series/parallel combinations of devices can be used for higher voltages and currents and for shorter transition times.

The circuit of Figure 8 has been used to switch a current of 20Athrough a coi I L of 100 µH with a switching time tₛ of 50 µs. More powerful switches, e.g. SCR's can be used to handle very high voltages and currents (~ 4 kV and 1000 Amps). Suitable snubber circuits may be introduced betweeen the anodes and cathodes of the SCR's in order to prevent their retrig- gering.

## Claims

1. An inductive circuit arrangement comprising four switches (S₁, S₂, S₃, S₄) connected in a bridge configuration, current supply terminals (T₁, T₂) from an electrical power supply (V₁) connected to opposite ends of the bridge, an inductive coil (L) connected across the bridge, means for operating the said switches (S₁, S₂, S₃, S₄) so that current can flow in either direction through the coil (L) depending on the setting of the switches, and a capacitor (C) connected across the bridge, characterised in that
a switch (S₅) is connected in series with the capacitor (C) and means are provided for operating the series switch (S₅) so as to connect the capacitor (C) across the coil (L) at least for a sufficient period of time until the voltage across the capacitor (C) reduces to zero and then isolate the capacitor (C) from the bridge configuration, and means are provided for replenishing ohmic losses in the circuit from an external source (V₂,V₁') when the series switch (S₅) is open.

2. The arrangement as claimed in Claim 1 characterised in that said means for replenishing ohmic losses comprises trickle charge means (V₂, D₇, R₁) connected to the capacitor (C) to enable the capacitor (C) to be charged to a predetermined voltage (V₂) after discharge.

3. The arrangement as claimed in Claim 2 characterised in that the said predetermined voltage (V2) is greater than the voltage (V₁) across the supply terminals (T₁, T₂).

4. The arrangement as claimed in Claim 2 or Claim 3 characterised in that unidirectional current flow devices (Dₛ, D₇) are connected in series with the respective current supply terminals (T₁, T₂) to the bridge configuration and the trickle charge means connected to the capacitor (C) to prevent flow of current in the reverse direction.

5. The arrangement as claimed in any one of Claims 2 to 4 characterised in that initiating charge means comprising an additional power supply is connected through a switch (Sₛ) to initially charge the capacitor (C) to a peak voltage (V₃) to provide the requisite electrical energy to establish the required current flow in the said coil (L) when desired (Fig. 3).

6. The arrangement as claimed in any one of the preceding claims characterised in that there is provided a switched parallel path across the bridge to maintain a substantially constant value of current through the current supply terminals irrespective of the settings of the switches in the bridge configuration.

7. The arrangement as claimed in Claim 1 characterised in that said means for replenishing ohmic losses comprises a further coil (L') togheterwith a further switch (Sg) to enable energy stored in said capacitor (C) to be transferred to and from said coil (L) and said further coil (L').

8. The arrangement as claimed in Claim 7 characterised in that the further switch is connected to a further bridge configuration and said further coil (L') is connected across the said further bridge configuration (Fig. 6).

9. The arrangement as claimed in any one of the preceding claims characterised in that the said switches (S₁, S₂, S₃, S₄, S₅) are shunted by unidirectional current flow devices (D₁, D₂, D₃, D₄, D₅).

10. An inductive circuit arrangement comprising two arms of a bridge configuration each arm comprising a pair of switches, (S₁, S₃ and S₂, S₄) which arms are connected at one of their ends to a common terminal (T₂), an inductive coil (L) connected between the arms, means for operating the said switches (S₁, S₂, S₃, S₄) so that current can flow in either direction through the coil (L) depending on the setting of the switches,
characterised in that
the other ends of the two arms are connected to different current supply terminals (T₁, T₃) each connected to respective electrical power supplies (V₁, V₄) at different voltage levels to enable different values of current flow to be established through the coil (L) in respective opposite directions, and in that switches (S₅, S₈) each connected in series with a respective capacitor (C₁, C₂) are connected across each arm respectively and means are provided for operating the series switches (S₅, S₈) so as to connect each respective capacitor (C₁, C₂) across the coil (L) at least for a sufficient period of time until the voltage across that capacitor (C₁ or C₂) reduces to zero and then isolate that capacitor (C₁, C₂) from the arms (Fig. 4).

11. The arrangement as claimed in Claim 10 characterised in that means are provided for replenishing ohmic losses in the circuit from external sources (V₂, Vₛ) when the respective switches (S₅, S₈) are open.

12. The arrangement as claimed in Claim 11 characterised in that said means for replenishing ohmic losses comprises respective trickle charge means (V₂, R₁ and Vₛ, R₂) connected to the respective capacitors (C₁, C₂) to enable the respective capacitors (C₁, C₂) to be charged to respective predetermined voltages (V₂ or Vₛ) after discharge.

13. The arrangement as claimed in Claim 12 characterised in that each of said predetermined voltages (V₂, Vₛ) is greater than the respective voltages (V₁, V₄) at the respective current supply terminals (T₁, T₃).

14. The arrangement as claimed in Claim 12 or Claim 13 characterised in that unidirectional current flow devices (D₇, D₁₀) are included in the respective trickle charge means.

15. The arrangement as claimed in any one of Claims 10 to 14 characterised in that unidirectional current flow devices (D₆, Dg) are included in the connections between said respective electrical power supplies (V₁, V₄) and said respective current supply terminals (T₁, T₃).

16. The arrangement as claimed in any one of Claims 10 to 15 characterised in that the switches (Sᵢ, S₂, S₃, S₄) in the said arms are each shunted by unidirectional current flow devices (D₁, D₂, D₃, D₄).

## Patentansprüche

1. Induktive Schaltungsanordnung mit vier Schaltern (S₁, S₂, S₃, S₄) die in einer Brückenkonfiguration verbunden sind, Stromversorgungsklemmen (T₁, T₂) von einer elektrischen Leistungsversorgung (V₁), die mit entgegengesetzten Enden der Brücke verbunden ist, einer induktiven Spule (L), die quer über die Brücke bzw. parallel zur Brücke verbunden ist, Mittel zum Betätigen der Schalter (S₁, S₂, S₃, S₄), so daß Strom in jede Richtung durch die Spule (L) in Abhängigkeit von der Stellung der Schalterfließen kann, und einem Kondensator (C), der parallel zur Brücke verbunden ist, dadurch gekennzeichnet, daß ein Schalter (S₅) in Reihe mit dem Kondensator (C) geschaltet und Mittel vorgesehen sind zur Betätigung des Reihenschalters (S₅), so daß der Kondensator (C) parallel zur Spule (L) zumindest für eine genügende Zeitdauer verbunden wird, bis sich die Spannung über den Kondensator (C) auf 0 verringert, und dann der Kondensator (C) von der Brückenkonfiguration getrennt wird, und Mittel vorgesehen sind, Ohm'sche Verluste in der Schaltung aus einer äußeren Quelle (V₂, V₁,) nachzuführen, wenn der Reihenschalter (S₅) geöffnet ist.

2. Anordnung nach Anspruch 1, dadurch gekennzeichnet, daß die Mittel zum Nachführen der Ohm'schen Verluste Pufferlandungsmittel (V₂, D₇, R₁) umfassen, die mit dem Kondensator (C) verbunden sind, um ein Aufladen des Kondensators (C) bis zu einer vorbestimmten Spannung (V₂) nach der Entladung zu ermöglichen.

3. Anordnung nach Anspruch 2, dadurch gekennzeichnet, daß die vorbestimmte Spannung (V₂) größer als die Spannung (V₁) zwischen den Versorgungsklemmen (T₁, T₂) ist.

4. Anordnung nach Anspruch 2 oder 3, dadurch gekennzeichnet, daß Einweg-Stromflußeinrichtungen (D₆, D₇) in Reihe mit den zugeordneten Stromversorgungsklemmen (T₁, T₂) zu der Brückenkonfiguration verbunden sind und die Pufferladungsmittel mit dem Kondensator (C) verbunden sind, um Stromfluß in der Umkehrrichtung zu verhindern.

5. Anordnung nach einem der Ansprüche 2 bis 4, dadurch gekennzeichnet, daß Einleit-Lademittel mit einer zusätzlichen Leistungsversorgung durch einen Schalter (Sₛ) verbunden sind, um den Kondensator (C) anfangs auf eine Spritzenspannung (V₃) aufzuladen, um die erforderliche elektrische Energie vorzusehen, den erforderlichen Stromfluß in der Spule (L), falls gewünscht (Fig. 3), herzustellen.

6. Anordnung nach einem der vorhergehenden Ansprüche, dadurch gekennzeichnet, daß ein geschalteter paralleler Pfad quer über die bzw. parallel zu der Brücke vorgesehen ist, um einen im wesentlichen konstanten Wert des Stroms durch die Stromversorgungsklemmen unabhängig von den Stellungen der Schalter in der Brückenkonfiguration aufrechtzuerhalten.

7. Anordnung nach Anspruch 1, dadurch gekennzeichnet, daß die Mittel zum Nachführen der Ohm'schen Verluste eine weitere Spule (L') zusammen mit einem weiteren Schalter (S) umfassen, um die Übertragung von in dem Kondensator (C) gespeicherter Energie zu der Spule (L) und der weiteren Spule (L') von dieser zu ermöglichen.

8. Anordnung nach Anspruch 7, dadurch gekennzeichnet, daß der weitere Schalter mit einer weiteren Brückenkonfuguration verbunden ist und daß die weiter Spule (L') quer über die bzw. parallel zu der weiteren Brückenkonfiguration (Fig. 6) geschaltet ist.

9. Anordung nach einem der vorhergehenden Ansprüche, dadurch gekennzeichnet, daß die Schalter (S₁, S₂, S₃, S₄, S₅) durch Einweg-Stromflußeinrichtungen (D₁, D₂, D₃, D₄, D₅) geshunted bzw. nebengeschlossen sind.

10. Induktive Schaltungsanordnung mit zwei Armen einer Brückenkonfiguration bzw. Brückenschaltung, von denen jeder Arm ein Paar von Schaltern (S₁, S₃, und S₂, S₄) umfasst, wobei die Arme mit einem ihrer Enden mit einer gemeinsamen Klemme (T₂) verbunden sind, einer induktiven Spule (L), die zwischen die Arme geschaltet ist, Mitteln zur Betätigung der Schalter (S₁, S₂, S₃, S₄), so daß Strom in jeder Richtung durch die Spule (L) in Abhängigkeit von der Einstellung der Schalterfließen kann, dadurch gekennzeichnet, daß die anderen Enden der zwei Arme mit verschiedenen Stromversorgungsklemmen (T₁, T₃) verbunden sind, von denen jede mit einer zugeordneten elektrischen Leistungsversorgung (V₁, V₄), mit verschiedenen Spannungspegeln verbunden ist, um unterschiedliche Werte für den Stromfluß möglich zu machen, der durch die Spule (L) in entsprechenden entgegengesetzten Richtungen herzustellen ist, und daß Schalter (S₅, S₈), von denen jeder in Reihe mit einem zugeordneten Kondensator (C₁, C₂) verbunden ist, jeweils parallel zu einem zugeordnetem Arm geschaltet ist und Mittel zum Betätigen der Reihenschalter (S₅, S₈), vorgesehen sind, um jeden zugeordneten Kondensator (C₁, C₂) parallel zur Spule (L) für zumindest eine genügende Zeitdauer zu schalten, bis sich die Spannung über den Kondensator (C₁, C₂) gegen Null verringert, und dann den Kondensator (C₁, C₂) von den Armen (Fig. 4) zu trennen.

11. Anordnung nach Anspruch 10, dadurch gekennzeichnet, daß Mittel vorgesehen sind, zum Nachführen Ohm'scher Verluste in der Schaltung aus einer äußeren Quelle (V₂, Vₛ), wenn die zugeordneten Schalter (S₅, S₈) geöffnet sind.

12. Anordnung nach Anspruch 11, dadurch gekennzeichnet, daß die Mittel zum Nachführen Ohm'scher Verluste zugeordnete Pufferladungsmittel (V₂, R₁ und Vₛ, R₂) umfassen, die mit den zugeordneten Kondensatoren (C₁, C₂) verbunden sind, um ein Aufladen der zugeordneten Kondensatoren (C₁, C₂) auf entsprechende vorbestimmte Spannungen (V₂ oder V₆) nach der Entladung möglich zu machen.

13. Anordnung nach Anspruch 12, dadurch gekennzeichnet, daß jede dervorbestimmten Spannungen (V₂, Vₛ) größer als die jeweiligen Spannungen (V₁, V₄) an den zugeordneten Stromversorgungsklemmen (T₁, T₃) sind.

14. Anordnung nach Anspruch 12 oder 13, dadurch gekennzeichnet, daß die Einweg-Stromflußeinrichtungen (D₇, D₁₀) in den zugeordneten Pufferladungsmitteln umfaßt sind.

15. Anordung nach einem der Ansprüche 10 bis 14, dadurch gekennzeichnet, daß die Einweg-Stromflußeinrichtungen (Dₛ, Dg) in den Verbindungen zwischen den zugeordneten elektrischen Leistungsversorgungen (V₁, V₄) und den entsprechenden Stromversorgungsklemmen (T₁, T₃) eingeschlossen sind.

16. Anordnung nach einem der Ansprüche 10 bis 15, dadurch gekennzeichnet, daß die Schalter (S₁, S₂, S₃, S₄) in den Armen jeweils durch Einweg-Stromflußeinrichtungen (D₁, D₂, D₃, D₄), geshunted, bzw. nebengeschlossen sind.

## Revendications

1. Circuit inductif comprenant quatre interrupteurs (Si, S₂, S₃, S₄) montés en pont, des bornes d'alimentation en courant (T₁, T₂) en provenance d'une source de courant électrique (V₁) montée aux extrémités opposées du pont, une bobine d'induction (L) montée en travers du pont, des moyens pour actionner les interrupteurs (S₁, S₂, S₃, S₄), de telle sorte qu'un courant puisse circuler dans l'une ou l'autre direction à travers la bobine (L) en fonction du positionnement des interrupteurs, et un condensateur (C) monté en travers du pont,
caractérisé en ce qu'un interrupteur(S₅) est monté en série avec le condensateur (C) et que des moyens sont prévus pour actionner l'interrupteur série (S₅) de façon à raccorder le condensateur (C) en travers de la bobine (L) pour au moins une durée suffisante pour que la tension en travers du condensateur (C) tombe à zéro et pour isoler ensuite le condensateur (C) du pont, et en ce que des moyens sont prévus pour compenser les pertes ohmiques dans le circuit à partir d'une source extérieure (V₂, V'₁) lorsque l'interrupteur série (S₅) est ouvert.

2. Circuit selon la revendication 1, caractérisé en ce que les moyens pour compenser les pertes ohmiques comportent des moyens de charge de compensation (V₂, D₇, R₁) raccordés au condensateur (C) pour permettre à celui-ci d'être chargé à une tension prédéterminée (V₂) après une décharge.

3. Circuit selon la revendication 2, caractérisé en ce que cette tension prédéterminée (V₂) est supérieure à la tension (V₁) aux bornes d'alimentation (T₁, T₂).

4. Circuit selon la revendication 2 ou la revendication 3, caractérisé en ce que des dispositifs unidirectionnels de flux de courant (Dₛ, D₇)sont montés en série avec les bornes d'alimentation en courant respectives (T₁, T₂)du pont et des moyens de charge de compensation raccordés au condensateur (C) pour empêcher le courant de circuler dans la direction inverse.

5. Circuit selon l'une quelconque des revendications 2 à 4, caractérisé en ce que les moyens de charge de déclenchement, comprenant une source de courant additionnelle, sont raccordés par l'intermédiaire d'un interrupteur (Sₛ) pour charger initialement le condensateur (C) à une tension de pointe (V₃) afin de procurer l'énergie électrique nécessaire pour établir le flux de courant requis dans la bobine (L) lorsqu'on le désire (figure 3).

6. Circuit selon l'une quelconque des revendications précédentes, caractérisé en ce qu'il est prévu un trajet parallèle commuté en travers du pont pour maintenir une valeur sensiblement constante du courant par l'intermédiaire des bornes d'alimentation en courant, quels que soient les positionnements des interrupteurs dans le pont.

7. Circuit selon la revendication 1, caractérisé en ce que les moyens pour compenser les pertes ohmiques comportent une autre bobine (L') avec un autre interrupteur (Sg) pour permettre de transférer l'énergie stockée dans le condensateur (C) à la bobine (L) et à la deuxième bobine (L') et à la transférer depuis ces bobines.

8. Circuit selon la revendication 7, caractérisé en ce que cet autre interrupteur est raccordé à un autre pont et que cette autre bobine (L') est montée en travers de cet autre pont (figure 6).

9. Circuit selon l'une quelconque des revendications précédentes, caractérisé en ce que les interrupteurs (S₁, S₂, S₃, S₄, S₅) sont shuntés par des dispositifs de flux de courant unidirectionnels (D₁, D₂, D₃, D₄, D5).

10. Circuit inductif comprenant deux branches d'un pont, chaque branche comprenant deux interrupteurs (S₁, S₃ et S₂, S₄), ces branches étant raccordées à l'une de leurs extrémités à une borne commune (T₂), une bobine d'induction (L) montée entre les branches, des moyens pour actionner les interrupteurs (S₁, S₂, S₃, S₄) de telle sorte que le courant puisse circuler dans l'une ou l'autre direction à travers la bobine (L) en fonction des positionnements des interrupteurs,
caractérisé en ce que les autres extrémités des deux branches sont raccordées à des bornes d'alimentation en courant différentes (T₁, T₃), raccordées chacune à des sources de courant électrique respectives (V₁, V₄) à différentes valeurs de tension pour permettre d'établir des valeurs différentes de flux de courant à travers la bobine (L) dans des directions opposées respectives, en ce que des interrupteurs (S₅, S₈), raccordés chacun en série avec un condensateur respectif (C₁, C₂),sont montés en travers de chaque branche respectivement et en ce que des moyens sont prévus pour actionner les interrupteurs série (S₅, S₈) de façon à raccorder chaque condensateur respectif (C₁, C₂)en travers de la bobine (L) pendant au moins une durée suffisante pour que la tension en travers de ce condensateur (C₁ou C₂) tombe à zéro et à isoler ensuite ce condensateur (C₁, C₂) des branches (figure 4).

11. Circuit selon la revendication 10, caractérisé en ce que des moyens sont prévus pour compenser les pertes ohmiques dans le circuit à partir de sources extérieures (V₂, Vₛ), lorsque les interrupteurs respectifs (S₅, S₈) sont ouverts.

12. Circuit selon la revendication 11, caractérisé en ce que les moyens pour compenser les pertes ohmiques comportent des moyens de charge de compensation respectifs (V₂, R₁ et V₆, R₂)raccordées aux condensateurs respectifs (C₁, C₂) pour permettre de charger les condensateurs respectifs (C₁, C₂) à leurs tensions prédéterminées respectives (V₂ ou Vₛ) après décharge.

13. Circuit selon la revendication 12, caractérisé en ce que chacune des tensions prédéterminées (V₂, Vₛ) est supérieure aux tensions respectives (V₁, V₄) au niveau des bornes d'alimentation en courant respectives (T₁, T₃).

14. Circuit selon la revendication 12 ou la revendication 13, caractérisé en ce que des dispositifs de flux de courant unidirectionnels (D₇, D₁₀)sont inclus dans les moyens de charge de compensation respectifs.

15. Circuit selon l'une quelconque des revendications 10 à 14, caractérisé en ce que des dispositifs de flux de courant unidirectionnels (D₆, Dg) sont inclus dans les raccordements entre ces sources de courant électrique respectives (V₁, V₄) et les bornes d'alimentation en courant respectives (T₁, T₃).

16. Circuit selon l'une quelconque des revendications 10 à 15, caractérisé en ce que les interrupteurs (S₁, S₂, S₃, S₄) dans les branches du pont sont shuntés chacun par des dispositifs de flux de courant unidirectionnels (D₁, D₂, D₃, D₄).
